# EUROPEAN PATENT SPECIFICATION

(11) **EP 2 980 269 B1**
(45) Date of publication and mention of the grant of the patent: **24.10.2018**
(21) Application number: 14775467.5
(22) Date of filing: 07.03.2014
(51) Int. Cl.: C23C 14/34, C23C 14/56, H01J 37/34, H01J 37/32, C23C 14/04, C23C 14/50, C23C 14/54

(54) **SPUTTERING DEVICE**
SPUTTERVORRICHTUNG
DISPOSITIF DE PULVÉRISATION CATHODIQUE

(30) Priority: 28.03.2013 JP 2013068067
(43) Date of publication of application: 03.02.2016
(73) Proprietor: Atsumitec Co., Ltd., Hamamatsu-shi, Shizuoka 433-8118 (JP)
(72) Inventor: UCHIYAMA, Naoki, Hamamatsu-shi Shizuoka 433-8118 (JP)
(74) Representative: MERH-IP Matias Erny Reichl Hoffmann Patentanwälte PartG mbB
(86) International application number: PCT/JP2014/055991
(87) International publication number: WO 2014/156567

(56) References cited:
- WO-A1-02/24321
- JP-A- H08 319 559
- JP-A- H09 213 634
- JP-A- S61 281 865
- JP-A- 2003 532 794
- JP-A- 2004 508 927
- JP-A- 2009 287 069
- US-A1- 2008 011 599
- US-A1- 2010 243 438
- US-A1- 2011 147 199

## Description

### Technical Field

The present invention relates to sputtering devices, and more particularly, to a sputtering device for manufacturing hydrogen sensors.

### Background Art

Hydrogen sensors using alloys that exhibit a change in color (optical characteristic) upon absorption of hydrogen have been known in the art (see Patent Document 1 by ways of example). A hydrogen sensor is produced by forming a plurality of thin films of alloy materials, such as Mg-Ni alloy, on a substrate. Such thin films are formed using a sputtering device (see Patent Document 2 by way of example). An inert gas (Ar gas) is introduced into a vacuum created in the sputtering device, and a target comprising an alloy material is heated by plasma discharge. The target is bombarded by ionized Ar, and fine particles of the alloy material are ejected from the target and form a film on the substrate. By introducing N₂ gas or O₂ gas together with Ar gas, it is possible to carry out reactive sputtering.

### Citation List

### Patent Literature

Patent Document 1: Japanese Unexamined Patent Publication No. 2011-219841
Patent Document 2: Japanese Unexamined Patent Publication No. H05-263228

### Summary of Invention

### Technical Problem

When forming films of a plurality of different materials on an identical substrate, however, a different mask needs to be placed between the substrate and the targets each time a film is to be formed using a different material, in order to previously delimit a region where the film is to be formed. A mask has patterned through holes formed therein, and fine particles of alloy material pass through the through holes to form a film on a predetermined region of the substrate. To form a film on a different region of the substrate, the substrate is taken out of the sputtering device, and after a mask having a different through-hole pattern is placed, the substrate is again put in the sputtering device. Taking out the substrate from the sputtering device and then placing a new mask in this manner leads to deterioration of the operation efficiency. Also, where an easily oxidizable alloy material is used to form a film, the film is exposed to the atmosphere when the substrate is taken out of the sputtering device, possibly causing change of thin film characteristics. In order to prevent the substrate from being exposed to the atmosphere when the substrate is taken out of the sputtering device, a separate vacuum chamber may be provided or a separate sputtering device may be arranged adjacent to the sputtering device. Such measures, however, lead to increase in the overall size of the sputtering device and require extra space and cost.

The sputtering device disclosed in Patent Document 2 is not configured to form films on respective regions of the substrate because the mask is fixed, and the substrate and the target are moved to control the film thickness. To move the target, a large-sized device is required, leaving the aforementioned space- and cost-related problems unsolved.

US 2011/147199 A1 describes a sputtering apparatus that comprises a substrate holder, and a screening member configured to screen a substrate mount surface of a surface of the substrate holder. The screening member comprises a first screening member configured to rotate about an axis In a first direction perpendicular to the substrate mount surface and screen at least a first area, and a second screening member configured to rotate about the axis and screen at least a second area.

WO 02/24321 A1 describes methods that include selectively delivering at least one of a plurality of materials to the surface of a substrate having a plurality of predefined regions to form a predefined coating on each of the regions. In the selective delivery of the materials, each of the plurality of materials is positioned for simultaneous delivery to the substrate.

The present invention was made in view of the aforementioned conventional art, and an object thereof is to provide a sputtering device which does not require a substrate to be taken out of the sputtering device or a new mask to be set in position in cases where films of different alloy materials are formed on respective regions of the substrate, and which is superior in terms of space and cost.

### Solution to Problem

The object is achieved by the invention according to claim 1. In particular, the present invention provides a sputtering device including: a vacuum chamber that is evacuated and hermetically sealed; a plurality of targets each fixed in the vacuum chamber and comprising a film forming material; a shield that selectively exposes, to an inside of the vacuum chamber, only a target among the plurality of targets out of which a film is to be formed; a substrate holding unit that holds a substrate on which fine particles ejected from the target are deposited to form a film; a first transfer unit that fixedly holds the substrate holding unit and moves the substrate holding unit within the vacuum chamber; a mask disposed between the substrate and the targets; a second transfer unit that moves the mask within the vacuum chamber; and a plurality of through-hole units having patterned through holes penetrating through the mask.

### Advantageous Effects of Invention

The sputtering device of the present invention does not require the substrate to be taken out of the sputtering device or a new mask to be set in position when films of different alloy materials are formed on respective regions of the substrate, and yet the sputtering device of the invention is superior in terms of space and cost. That is, in cases where after the formation of a film with use of a desired target, a film with a different pattern needs to be formed using a different target, the substrate is moved to the location of the corresponding target by the first transfer unit, and if necessary, the mask is moved using the second transfer unit such that the substrate is positioned properly with respect to a desired through-hole unit. Accordingly, films having different patterns can be formed using a plurality of alloy materials within the sputtering device.

### Brief Description of Drawings

FIG. 1 is a sectional view taken along line A-A in FIG. 2 and schematically illustrating a sputtering device according to the present invention.
FIG. 2 is a sectional view taken along line D-D in FIG. 1.
FIG. 3 is a sectional view taken along line A-A in FIG. 2 and illustrating a state of the sputtering device different from that illustrated in FIG. 1.
FIG. 4 is a sectional view taken along line B-B in FIG. 2.
FIG. 5 is a sectional view taken along line B-B in FIG. 2 and illustrating a state of the sputtering device different from that illustrated in FIG. 4.
FIG. 6 is a sectional view taken along line C-C in FIG. 2.

### Description of Embodiments

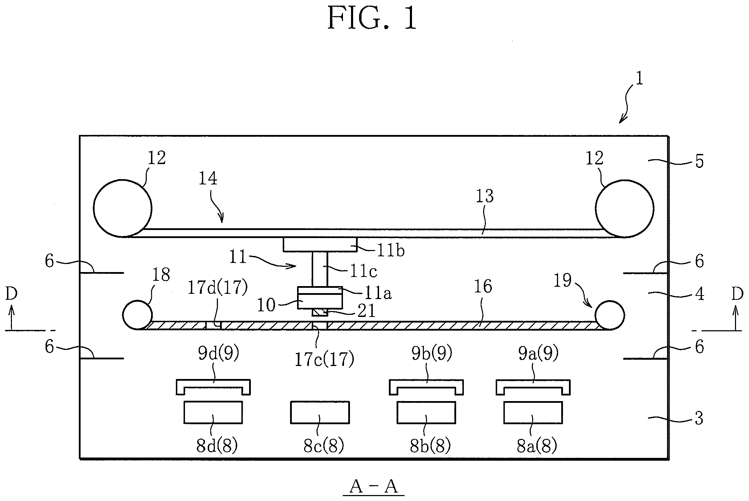

As illustrated in FIG. 1, a sputtering device 1 according to the present invention has a substantially hermetically sealed space serving as a vacuum chamber 2. The vacuum chamber 2 is composed roughly of three regions, namely, a target section 3, a sputter section 4, and a substrate section 5. The regions 3 to 5 communicate with each other and may be partitioned to a certain extent by partition walls 6 insofar as the regions 3 to 5 can communicate with each other. The vacuum chamber 2 is evacuated to create a vacuum therein. A plurality of (in the figure, four) targets 8 are fixedly disposed in the target section 3 forming part of the vacuum chamber 2. The targets 8 are materials out of which films are formed on a substrate 10, and more specifically, the targets are masses of metals (alloys). In the illustrated example, WO₃, Mg-Ti, Mg-Ni and Pd are used as targets 8a to 8d, respectively.

The targets 8 are associated respectively with shields 9 (9a to 9d), such as shutters by way of example. Specifically, the other targets than the one used for film formation are covered with their respective shields 9, so that only the target 8 used for film formation is selectively exposed to the inside of the vacuum chamber 2. The substrate 10, on which films are formed using the targets 8, is held by a substrate holding unit 11 disposed in the substrate section 5. The substrate holding unit 11 includes a gripper 11a for gripping the substrate 10 and a base 11b, and the gripper 11a and the base 11b are coupled to each other by an elongate coupler 11c. Among the parts constituting the substrate holding unit 11, the base 11b is positioned in the substrate section 5. The coupler 11c extends toward the sputter section 4, and the gripper 11a is positioned in the sputter section 4. Thus, the substrate 10 held by the gripper 11a is located within the sputter section 4.

The substrate holding unit 11 is movable within the vacuum chamber 2 while being fixedly held by a first transfer unit 14. Specifically, the first transfer unit 14 includes a pair of first rollers 12 disposed within the substrate section 5, and a belt 13 stretched between the first rollers 12. An output shaft of a first motor 15 is coupled to one of the first rollers 12. Thus, as the first motor 15 is driven, the first roller 12 that is coupled to the motor 15 is rotated by the output shaft. As a result, the driven roller, namely, the other one of the first rollers 12 also rotates, so that as the belt 13 moves, the substrate holding unit 11 moves within the vacuum chamber 2. That is, the substrate 10 held by the substrate holding unit 11 moves within the sputter section 4 along the direction of movement of the belt 13.

A mask 16 is disposed within the sputter section 4 and located between the substrate 10 and the targets 8. The mask 16 has through holes 17 formed therein in a patterned manner. Forming through holes in a patterned manner denotes herein that the through holes 17 form a desired through-hole pattern when viewed from the target side. The through holes 17 are formed as discrete through-hole units 17a to 17f each including one or more through holes. In the illustrated example, six through-hole units 17a to 17f in total are formed. Also, in the illustrated example, the through-hole units 17a to 17f each include three through holes 17 aligned vertically. The mask 16 is moved within the vacuum chamber 2 by a second transfer unit 19. The second transfer unit 19 includes a pair of second rollers 18. The mask 16 is formed as an elongate sheet and stretched between the pair of second rollers 18. An output shaft of a second motor 20 is coupled to one of the second rollers 18. Thus, as the second motor 20 is driven, the second roller 18 that is coupled to the motor 20 is rotated by the output shaft. As a result, the driven roller, namely, the other one of the second rollers 18 also rotates, so that the mask 16 moves within the vacuum chamber 2 (sputter section 4).

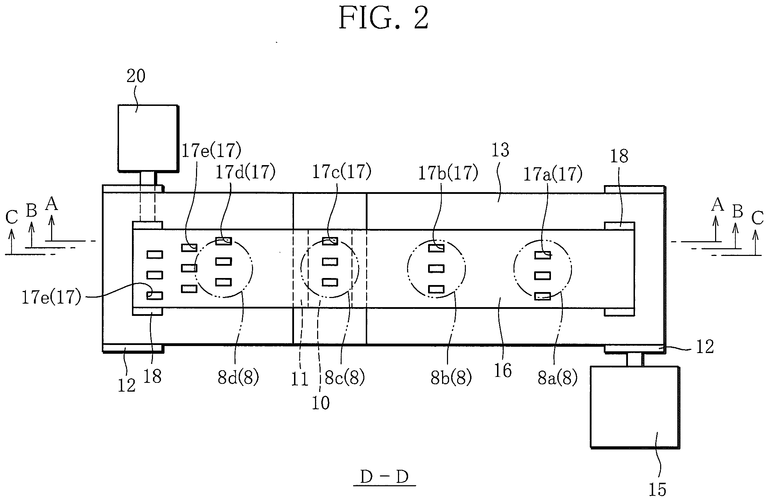

The through holes 17 are formed as a plurality of patterned through-hole units 17a to 17f as mentioned above, and the through-hole units 17a to 17f are associated with the targets 8. In the illustrated example, as is clear from FIG. 2, the through-hole unit 17a is associated with the target 8a, the through-hole unit 17b is associated with the target 8b, the through-hole unit 17c is associated with the target 8c, and the through-hole units 17d to 17f are associated with the target 8d. That is to say, only the target 8d is associated with a plurality of through-hole units 17d to 17f.

To actually form films on the substrate 10 using the sputtering device 1 configured as described above, the procedure explained below is followed.

First, a substrate is set in the gripper 11a of the substrate holding unit 11, and the vacuum chamber 2 is evacuated to create a vacuum therein. Then, an inert gas (Ar gas) is introduced into the vacuum chamber 2. If necessary, N₂ gas or O₂ gas is also introduced into the vacuum chamber. Subsequently, the first motor 15 is driven to move the belt 13 together with the substrate holding unit 11. The substrate 10 is positioned first in front of the Mg-Ni target 8c, as shown in FIG. 1. At this time, the positioning of the mask 16 is adjusted appropriately using the second motor 20 so that the through-hole unit 17c formed in the mask 16 may be situated between the substrate 10 and the target 8c.

Then, only the shield 9c is opened, and with the shield 9c kept open, the target 8c is heated by plasma discharge, whereupon the target 8c is bombarded by ionized Ar, and fine Mg-Ni particles are ejected from the target 8c toward the substrate 10 through the through-hole unit 17c, with the result that a film is formed according to the pattern of the through-hole unit 17c. Where the target 8 used is changed, films are formed on the same principle. The Mg-Ni particles are deposited as a first layer 21 on the substrate 10.

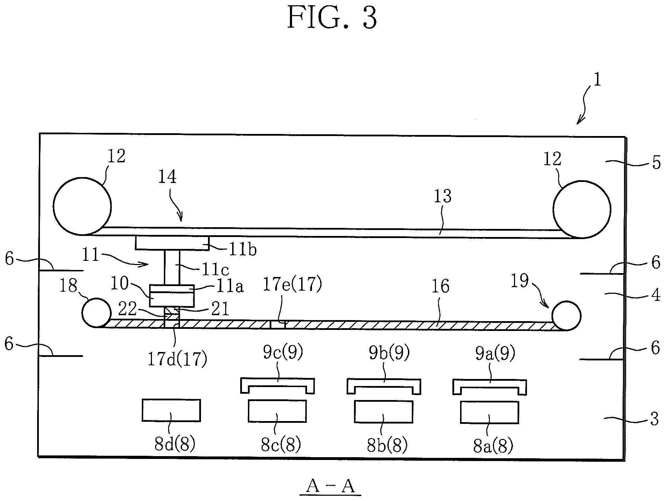

Then, as shown in FIG. 3, the substrate 10 is positioned in front of the Pd target 8d. In the illustrated example, the through-hole unit 17d of the mask 16 situated between the target 8d and the substrate 10 has a pattern shape identical with that of the through-hole unit 17c. The shield 9d alone is opened, and using the target 8d, a film is formed on the substrate 10. As a result, a Pd layer as a second layer 22 is formed directly over the first layer 21. When forming films according to an identical pattern as in the illustrated case, the position of the substrate 10 relative to the target 8d to be used this time is adjusted to be the same as that of the substrate 10 relative to the previously used target 8c, whereby the second layer 22 can be formed over the first layer 21.

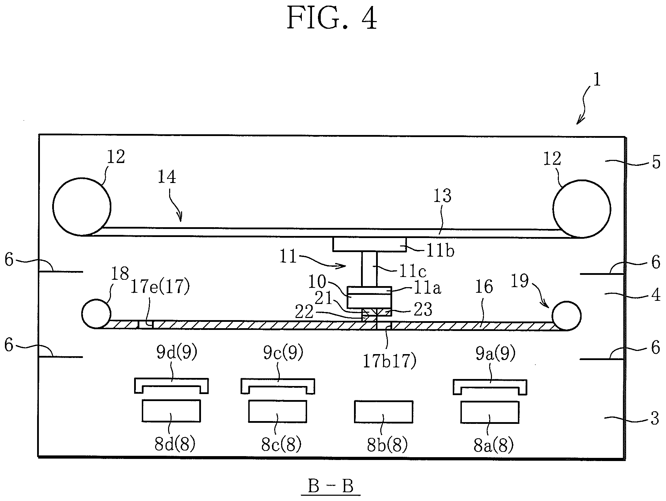

Subsequently, as shown in FIG. 4, the shield 9b alone is opened, and the substrate 10 is positioned in front of the Mg-Ti target 8b. The second motor 20 is driven to adjust the positioning of the mask 16 such that the through-hole unit 17b is situated between the substrate 10 and the target 8b. Then, as a third layer 23, a Mg-Ti layer is formed on the substrate 10. In the example illustrated in FIG. 4, the through-hole unit 17b has a through-hole pattern different from that of the through-hole unit 17c, and also the film forming position on the substrate 10 is slightly shifted. Consequently, the third layer 23 is formed directly on the substrate 10.

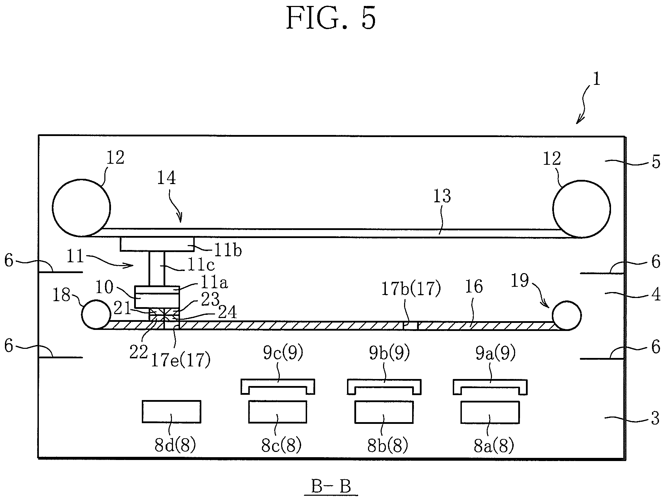

Then, as shown in FIG. 5, only the shield 9d is opened, and the substrate 10 is again positioned in front of the Pd target 8d. The mask 16 is also moved such that, in this case, the through-hole unit 17e having a through-hole pattern identical with that of the through-hole unit 17b is situated between substrate 10 and the target 8d. At this time, the position of the substrate 10 relative to the target 8d to be used this time is adjusted to be the same as that of the substrate 10 relative to the previously used target 8b. With the substrate thus positioned, a Pd layer as a fourth layer 24 is formed directly over the third layer 23.

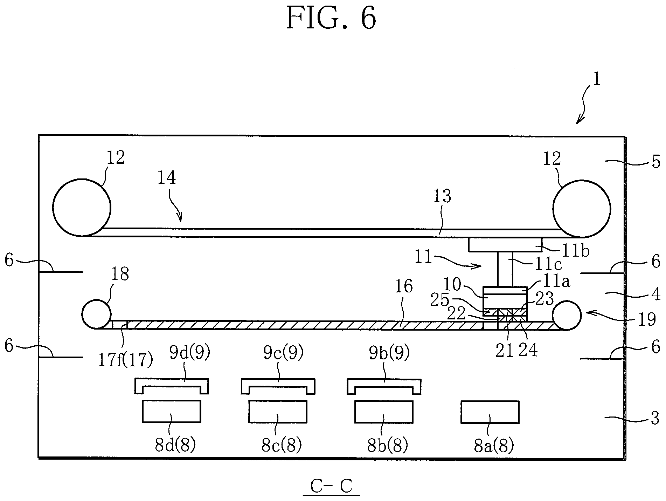

Subsequently, as shown in FIG. 6, only the shield 9a is opened, and the substrate 10 is positioned in front of the WO₃ target 8a. The second motor 20 is driven to adjust the positioning of the mask 16 such that the through-hole unit 17a is situated between the substrate 10 and the target 8a. In the example illustrated in FIG. 6, the through-hole unit 17a has a through-hole pattern different from those of the through-hole units 17b and 17c, and also the film forming position on the substrate 10 is slightly shifted from those for the targets 8b and 8c. With the substrate thus positioned, a WO₃ layer as a fifth layer 25 is formed directly on the substrate 10. Where a Pd layer needs to be formed directly over the fifth layer 25, the through-hole unit 17f may be used to form a film of Pd.

In this manner, sputtering can be carried out while changing the positioning of the mask 16 without the need to take out the substrate 10 from the sputtering device 1 each time the target 8 is changed. That is, even in cases where the pattern of the mask needs to be changed while films are formed using a plurality of targets 8, the substrate 10 can be moved to the location of the necessary target 8 by the first transfer unit 14, and if necessary, the mask 16 is moved using the second transfer unit 19 such that the substrate 10 is positioned properly with respect to the desired through-hole unit 17. Accordingly, films of different patterns and different alloy materials can be formed within the sputtering device 1, and it is possible to improve the quality of films formed using easily oxidizable targets, for example. Thus, even in cases where films are formed using different alloy materials on respective predetermined regions of the substrate 10, it is not necessary to take out the substrate 10 from the sputtering device 1 in order to allow a new mask 16 to be set. If, like Pd in the illustrated example, a certain target is expected to be used in conjunction with a plurality of through-hole units, a plurality of through-hole units 17d to 17f may be prepared for such a target 8d, and since the target 8 need not be provided for each of the through-hole units, space and cost can advantageously be saved.

In hydrogen sensors, alloys such as the aforementioned Mg-Ni alloy are used for storing hydrogen. It has been known that a Pd layer additionally deposited as a catalyst layer serves to improve the hydrogen absorbing properties. Thus, in the case of the Pd target 8d, the through-hole unit 17d having the same through-hole pattern as the through-hole unit 17c with which the Mg-Ni target 8c is associated may be used to cover the first layer 21 (hydrogen storage layer) with the second layer 22 (catalyst layer). The aforementioned sputtering device 1 is therefore especially suited for the manufacture of hydrogen sensors. In semiconductor applications, sputtering needs to be performed such that neighboring patterns do no overlap each other. In the case of hydrogen sensors, on the other hand, overlapping of edges of neighboring alloy layers does not significantly affect the function of hydrogen sensors because hydrogen sensors are expected to exhibit a visually observable change in color upon absorption of hydrogen. It is therefore unnecessary to provide the sputtering device with a mechanism for precisely adjusting the distance between the through-hole units 17 and the substrate 10 or between the targets 8 and the mask 16 in order to prevent neighboring layers from overlapping each other, and the sputtering device may have a simplified structure. Also in this respect, the aforementioned sputtering device 1 is suited for the manufacture of hydrogen sensors.

### <Aspects of the Invention>

To achieve the aforementioned object, the present invention provides a sputtering device including: a vacuum chamber that is evacuated and hermetically sealed; a plurality of targets each fixed in the vacuum chamber and comprising a film forming material; a shield that selectively exposes, to an inside of the vacuum chamber, only a target among the plurality of targets out of which a film is to be formed; a substrate holding unit that holds a substrate on which fine particles ejected from the target are deposited to form a film; a first transfer unit that fixedly holds the substrate holding unit and moves the substrate holding unit within the vacuum chamber; a mask disposed between the substrate and the targets; a second transfer unit that moves the mask within the vacuum chamber; and a plurality of through-hole units having patterned through holes penetrating through the mask.

Preferably, the first transfer unit includes a belt stretched between a pair of first rollers, the mask is formed as an elongate sheet stretched between a pair of second rollers, the first rollers and the second rollers are coupled to output shafts of first and second motors, respectively, the plurality of through-hole units are formed in a manner associated with the targets, and at least one of the targets is associated with two or more of the plurality of through-hole units.

### Reference Signs List

- 1:: sputtering device
- 2:: vacuum chamber
- 3:: target section
- 4:: sputter section
- 5:: substrate section
- 6:: partition wall
- 8:: target
- 9:: shield
- 10:: substrate
- 11:: substrate holding unit
- 12:: first roller
- 13:: belt
- 14:: first transfer unit
- 15:: first motor
- 16:: mask
- 17:: through hole
- 18:: second roller
- 19:: second transfer unit
- 20:: second motor
- 21:: first layer
- 22:: second layer
- 23:: third layer
- 24:: fourth layer
- 25:: fifth layer

## Claims

1. A sputtering device (1) comprising:
a vacuum chamber (2) that is evacuated and hermetically sealed;
a plurality of targets (8) each and fixed in the vacuum chamber (2) and comprising a film forming material;
a shield (9) that selectively exposes, to an inside of the vacuum chamber (2), only a target (8) among the plurality of targets (8) out of which a film is to be formed;
a substrate holding unit (11) that holds a substrate (10) on which fine particles ejected from the target (8) are deposited to form a film;
a first transfer unit (14) that fixedly holds the substrate holding unit (11) and moves the substrate holding unit (11) within the vacuum chamber (2);
a mask (16) disposed between the substrate (10) and the targets (8); and
a second transfer unit (19) that moves the mask (16) within the vacuum chamber (2); **characterized by**
a plurality of through-hole units (17a-17f) having patterned through holes (17) penetrating through the mask (16), wherein:
the first transfer unit (14) includes a belt (13) stretched between a pair of first rollers (12) and positions the substrate (10) in front of one of the plurality of targets (8),
the mask (16) Is formed as an elongate sheet stretched between a pair of second rollers (18),
the first rollers (12) and the second rollers (18) are coupled to output shafts of first and second motors (15, 20), respectively,
the plurality of through-hole units (17a-17f) are formed in a manner associated with the targets (8), and
at least one of the targets (8) is associated with two or more of the plurality of through-hole units (17a-17f).

## Patentansprüche

1. Sputtervorrichtung (1), die Folgendes umfasst:
eine Vakuumkammer (2), die evakuiert und luftdicht abgedichtet ist;
mehrere Targets (8), die jeweils in der Vakuumkammer (2) befestigt sind und ein schichtbildendes Material umfassen;
eine Abschirmung (9), die wahlweise lediglich ein Target (8) aus den mehreren Targets (8), aus dem eine Schicht gebildet werden soll, zu einer Innenseite der Vakuumkammer (2) freilegt;
eine Substrathalteinheit (11), die ein Substrat (10) hält, auf das feine Teilchen, die von dem Target (8) ausgestoßen werden, aufgebracht werden, um eine Schicht zu bilden;
eine erste Übertragungseinheit (14), die die Substrathalteeinheit (11) feststehend hält und die Substrathalteeinheit (11) in der Vakuumkammer (2) bewegt;
eine Maske (16), die zwischen dem Substrat (10) und den Targets (8) angeordnet ist; und
eine zweite Übertragungseinheit (19), die die Maske (16) in der Vakuumkammer (2) bewegt, **gekennzeichnet durch**
mehrere Durchgangslocheinheiten (17a-17f), die strukturierte Durchgangslöcher (17) aufweisen, die die Maske (16) durchdringen, wobei:
die erste Übertragungseinheit (14) einen Riemen (13) enthält, der zwischen einem Paar erster Rollen (12) gespannt ist und das Substrat (10) vor einem der mehreren Targets (8) positioniert,
die Maske (16) als eine langgestreckte Folie gebildet ist, die zwischen einem Paar zweiter Rollen (18) gespannt ist,
die ersten Rollen (12) und die zweiten Rollen (18) mit Ausgangswellen eines ersten bzw. eines zweiten Motors (15, 20) gekoppelt sind,
die mehreren Durchgangslocheinheiten (17a-17f) in der Weise gebildet sind, dass sie den Targets (8) zugeordnet sind, und
mindestens eines der Targets (8) zwei oder mehreren der mehreren Durchgangslocheinheiten (17a-17f) zugeordnet ist.

## Revendications

1. Dispositif de pulvérisation cathodique (1) comprenant :
une chambre à vide (2) qui est évacuée et qui est hermétiquement scellée ;
une pluralité de cibles (8) qui sont chacune fixées dans la chambre à vide (2) et qui comprennent un matériau de formation de film ;
un écran (9) qui expose sélectivement, vers l'intérieur de la chambre à vide (2), une seule cible (8) parmi la pluralité de cibles (8) à partir desquelles il s'agit de former un film ;
une unité de maintien de substrat (11) qui maintient un substrat (10) sur lequel des fines particules éjectées depuis la cible (8) sont déposées pour former un film ;
une première unité de transfert (14) qui maintient de manière fixe l'unité de maintien de substrat (11) et qui déplace l'unité de maintien de substrat (11) à l'intérieur de la chambre à vide (2) ;
un masque (16) disposé entre le substrat (10) et les cibles (8) ; et
une seconde unité de transfert (19) qui déplace le masque (16) à l'intérieur de la chambre à vide (2) ; **caractérisé par**
une pluralité d'unités à trous traversants (17a-17f) ayant des trous traversants disposés en motif (17) qui pénètrent à travers le masque (17) ;
dans lequel :
la première unité de transfert (14) inclut une courroie (13) tendue entre une paire de premiers rouleaux (12) et positionne le substrat (10) en face de l'une de la pluralité de cibles (8),
le masque (16) est formé comme une feuille allongée étirée entre une paire de seconds rouleaux (18),
les premiers rouleaux (12) et les seconds rouleaux (18) sont couplés à des arbres de sortie d'un premier et d'un second moteur (15, 20), respectivement,
la pluralité d'unités à trous traversants (17a-17f) sont formées d'une manière associée avec les cibles (8), et
l'une au moins des cibles (8) est associée à deux ou plusieurs de la pluralité d'unités à trous traversants (17a-17f).
